(19) Europäisches Patentamt
European Patent Office
Office européen des brevets

(11) **EP 3 391 063 B1**

(12) **EUROPÄISCHE PATENTSCHRIFT**

(45) Veröffentlichungstag und Bekanntmachung des Hinweises auf die Patenterteilung:
**20.04.2022   Patentblatt 2022/16**

(21) Anmeldenummer: **16810376.0**

(22) Anmeldetag: **14.12.2016**

(51) Internationale Patentklassifikation (IPC):
***G01R 31/62*** *(2020.01)*

(52) Gemeinsame Patentklassifikation (CPC):
**G01R 31/62;** G01R 29/20

(86) Internationale Anmeldenummer:
**PCT/EP2016/080971**

(87) Internationale Veröffentlichungsnummer:
**WO 2017/102828 (22.06.2017 Gazette 2017/25)**

(54) **MOBILE TRANSFORMATORPRÜFVORRICHTUNG UND VERFAHREN ZUM PRÜFEN EINES LEISTUNGSTRANSFORMATORS**

MOBILE TRANSFORMER TEST DEVICE AND METHOD FOR TESTING A POWER TRANSFORMER

DISPOSITIF DE TEST DE TRANSFORMATEUR MOBILE ET PROCÉDÉ DE TEST D'UN TRANSFORMATEUR DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2015   AT 510822015**

(43) Veröffentlichungstag der Anmeldung:
**24.10.2018   Patentblatt 2018/43**

(73) Patentinhaber: **Omicron electronics GmbH**
**6833 Klaus (AT)**

(72) Erfinder:
 • **KLAPPER, Ulrich**
   **6830 Rankweil (AT)**
 • **KUKUK, Matthias**
   **6923 Lauterach (AT)**
 • **ENGELEN, Christoph**
   **6830 Rankweil (AT)**
 • **FLAX, Dirk**
   **6850 Dornbirn (AT)**

(74) Vertreter: **Banzer, Hans-Jörg**
**Kraus & Weisert**
**Patentanwälte PartGmbB**
**Thomas-Wimmer-Ring 15**
**80539 München (DE)**

(56) Entgegenhaltungen:
EP-A1- 1 398 644     EP-A1- 1 653 238
EP-A1- 2 787 357     CN-A- 104 749 537
JP-A- S6 040 971

**Beschreibung**

GEBIET DER ERFINDUNG

Die Erfindung betrifft eine Transformatorprüfvorrichtung und ein Verfahren zum Prüfen von Transformatoren, insbesondere von Leistungstransformatoren. Die Erfindung betrifft insbesondere derartige Vorrichtungen und Verfahren, mit denen Messungen durchgeführt werden, die Rückschlüsse auf magnetische Eigenschaften des Transformatorkerns erlauben.

HINTERGRUND

Transformatoren werden als Bestandteile von Energieversorgungsnetzen verwendet. Transformatoren können zur Spannungswandlung oder Stromwandlung eingesetzt werden.

Die Bestimmung von Eigenschaften eines Transformators durch eine Transformatorprüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Transformatorprüfungen beinhalten die Bestimmung eines statischen Widerstands, die Bestimmung eines dynamischen Widerstands, die Bestimmung eines Übersetzungsverhältnisses und/oder die Bestimmung einer Streuimpedanz oder Streuinduktivität.

Die herkömmlichen Techniken der Transformatorprüfung liefen jedoch nur begrenzte Aussagen zur Charakterisierung von magnetischen Eigenschaften einer Hauptinduktivität des Transformators. Zusätzliche Informationen, die Rückschlüsse auf die magnetischen Eigenschaften der Hauptinduktivität des Transformators ermöglichen, wären nicht nur zur genaueren Parametrisierung eines Ersatzschaltbilds des Transformators, sondern auch zur genaueren Erkennung von Fehlerzuständen wünschenswert. Beispielsweise könnten Beschädigungen oder Veränderungen des Transformatorkerns besser erkannt werden, wenn zusätzliche Messgrößen bereitstehen würden, die von den magnetischen Eigenschaften des Transformatorkerns abhängen.

Die Druckschrift EP 1 653 238 A1 offenbart die Bestimmung von nominellen Transformatorkenndaten eines Transformators. Dabei kann ein Remanenzfaktor durch Aufnahme einer Hysteresekurve bestimmt werden.

Die Druckschrift EP 1 398 644 A1 beschreibt das Testen eines Transformators. Dabei wird die Hysteresekurve des Transformators gemessen, um daraus ein Simulationsmodell abzuleiten, welches das Verhalten des Transformators bei unterschiedlichen Frequenzen simuliert.

Die Druckschrift EP 2 787 357 A1 offenbart ein Testen eines Transformators. Dabei kann eine Hauptinduktivität in ihrem zeitlichen Verlauf (Hysteresekurve) aus der Differenz des gesamten Magnetisierungsstroms und den ohmschen Strömen durch berechnete Widerstände ermittelt werden.

Die Druckschrift CN 104 749 537 A betrifft ein Messverfahren einer Hysteresekurve eines Stromwandlers.

Die Druckschrift JP 600 40971 A beschreibt ein Verfahren zum genauen Messen von B-H-Eigenschaften eines Eisenkerns einer Transformators.

ZUSAMMENFASSUNG DER ERFINDUNG

Es besteht ein Bedarf an Vorrichtungen und Verfahren, mit denen eine Transformatorprüfung verbessert werden kann. Es besteht insbesondere ein Bedarf an Vorrichtungen und Verfahren, mit denen Messgrößen erfassbar sind, die Rückschlüsse auf magnetische Eigenschaften einer Hauptinduktivität des Transformators, damit zusammenhängende Fehlerzustände oder andere Eigenschaften des Transformators ermöglichen.

Gemäß der Erfindung wird im unabhängigen Anspruch 1 eine mobile Transformatorprüfvorrichtung zum Prüfen eines Leistungstransformators und im unabhängigen Anspruch 14 ein Verfahren zum Prüfen eines Leistungstransformators definiert. Nach Ausführungsbeispielen werden eine Transformatorprüfvorrichtung und ein verfahren zum Prüfen eines Transformators angegeben, bei denen die Transformatorprüfvorrichtung eingerichtet ist, um eine B-H-Kennlinie des Transformators aufzunehmen oder charakteristische Parameter der B-H-Kennlinie zu bestimmen. Dazu kann die Transformatorprüfvorrichtung eingerichtet sein, um einen Gleichstrom oder einen Wechselstrom als Prüfsignal in wenigstens eine Wicklung des Transformators einzuprägen. Die Stromstärke des eingeprägten Gleichstroms oder Wechselstrom kann als zur magnetischen Feldstärke proportionale Messgröße in einer Steuer- oder Regelschleife eingestellt und überwacht werden. Eine Spannung, die in wenigstens einer Wicklung des Transformators abfällt, kann als Prüfantwort erfasst werden. Ein Zeitintegral der Spannung kann durch eine Integratorschaltung oder durch Abtasten und numerische Aufintegration der Spannung ermittelt werden. Das Zeitintegral der Spannung gibt ein Maß für die magnetische Flussdichte.

Die Transformatorprüfvorrichtung ist eine mobile Transformatorprüfvorrichtung. Die Transformatorprüfvorrichtung ist zur Prüfung von Leistungstransformatoren eingerichtet.

Die Transformatorprüfvorrichtung kann eingerichtet sein, um physikalische Eigenschaften des Transformators aus der B-H-Kennlinie zu ermitteln. Durch eine Interpretation der physikalischen Eigenschaften wird eine differenziertere Diagnose des Transformators ermöglicht.

Zusätzlich zur Erfassung der B-H-Kennlinie kann die Transformatorprüfvorrichtung auch eingerichtet sein, ein Wicklungsverhältnis oder - insbesondere für Dreiphasentransformatoren - mehrere Wicklungsverhältnisse, Wicklungswiderstände, Streuinduktivitäten oder Streuimpedanzen oder andere Kenngrößen des Transformators zu ermitteln. Die Informationen über die B-H-Kennlinie können zusätzlich zu diesen Kenngrößen verwendet werden, um ein Ersatzschaltbild des Transformators zu parametrisieren oder um auf physikalische Parameter des Transformators Rückschlüsse zu ziehen.

Die Transformatorprüfvorrichtung kann beispielsweise eingerichtet sein, um eine Beschädigung des Kerns, die Anwesenheit eines kleinen Luftspalts, Aussagen über eine Überspannungsfestigkeit und/oder Aussagen über einen Wirkungsgrad automatisch aus den von der Transformatorprüfvorrichtung ermittelten Kenngrößen, die Informationen über die B-H-Kennlinie beinhalten, zu ermitteln.

Die Transformatorprüfvorrichtung muss nicht notwendig eingerichtet sein, um alle Proportionalitätskonstanten, die die Skalierung der B- und H-Achse der B-H-Kennlinie definieren, zu ermitteln. Beispielsweise kann die Transformatorprüfvorrichtung so eingerichtet sein, dass die Stromstärke, die in eine Wicklung des Transformators eingeprägt wird, als Maß für die magnetische Feldstärke erfasst wird, ohne dass alle Proportionalitätskonstanten, die den Zusammenhang zwischen Stromstärke und magnetischer Feldstärke beeinflussen, berücksichtigt werden müssen. Alternativ oder zusätzlich kann die Transformatorprüfvorrichtung so eingerichtet sein, dass ein Zeitintegral der Spannung, die über einer Wicklung des Transformators als Reaktion auf die als Prüfsignal eingeprägte gleich oder Wechselspannung abfällt, als Maß für die magnetische Flussdichte ermittelt wird, ohne dass alle Proportionalitätskonstanten, die den Zusammenhang zwischen Zeitintegral der Spannung und magnetischer Flussdichte beeinflussen, berücksichtigt werden müssen.

Eine Transformatorprüfvorrichtung nach einem Ausführungsbeispiel umfasst Anschlüsse zur lösbaren Verbindung der Transformatorprüfvorrichtung mit einem Transformator. Die Transformatorprüfvorrichtung umfasst eine Quelle zum Erzeugen eines Prüfsignals für den Transformator. Die Transformatorprüfvorrichtung umfasst eine Auswerteschaltung, die eingerichtet ist, um basierend auf dem Prüfsignal und einer Prüfantwort des Transformators Informationen über eine B-H-Kennlinie des Transformators, die eine Abhängigkeit einer magnetischen Flussdichte von einer magnetischen Feldstärke im Transformator definiert, zu bestimmen.

Die Auswerteschaltung kann eingerichtet sein, um Datenpunkte der B-H-Kennlinie oder wenigstens einen Parameter der B-H-Kennlinie aus dem Prüfsignal und der Prüfantwort zu bestimmen.

Die Auswerteschaltung kann eingerichtet sein, um Datenpunkte einer $I(t) - \int U(t')dt'$-Kurve oder wenigstens einen Parameter der $I(t) - \int U(t')dt'$-Kurve aus dem Prüfsignal und der Prüfantwort zu bestimmen.

Die Auswerteschaltung kann eingerichtet sein, um ein Zeitintegral einer Spannung an wenigstens einer Wicklung des Transformators zu ermitteln.

Die Auswerteschaltung kann eingerichtet sein, um aus dem Zeitintegral der Spannung die magnetische Flussdichte oder eine zur magnetischen Flussdichte proportionale Größe zu bestimmen.

Die Auswerteschaltung kann eingerichtet sein, um einen in wenigstens einer Wicklung des Transformators fließenden Strom zu erfassen. Zur Erfassung des Stroms kann eine Stellgröße einer Stromquelle in der Transformatorprüfvorrichtung erfasst werden. Die Stromquelle kann ein internes Amperemeter oder eine andere Strommesseinrichtung aufweisen, die zur Regelung der Stromstärke verwendet wird. Die dadurch erfasste Stromstärke kann als Maß für die magnetische Feldstärke bei der Ermittlung der Informationen über die B-H-Kennlinie verwendet werden.

Die Auswerteschaltung kann eingerichtet sein, um aus dem in wenigstens einer Wicklung des Transformators fließenden Strom die magnetische Feldstärke zu bestimmen.

Die Quelle kann eine Stromquelle sein, die den durch die wenigstens eine Wicklung des Transformators fließenden Strom als das Prüfsignal bereitstellt. Die Stromquelle kann steuerbar sein, um wahlweise einen Gleichstrom oder einen Wechselstrom als Prüfsignal bereitzustellen. Die Stromquelle kann steuerbar sein, um Wechselströme mit unterschiedlicher Frequenz als Prüfsignal bereitzustellen.

Das Prüfsignal kann ein Wechselstrom sein.

Die Transformatorprüfvorrichtung kann eingerichtet sein, um das Prüfsignal an einer Oberspannungsseite oder an einer Unterspannungsseite des Leistungstransformators einzuspeisen.

Die Auswerteschaltung kann eingerichtet sein, um eine Steigung der B-H-Kennlinie an einem Nulldurchgang zu ermitteln.

Die Auswerteschaltung kann alternativ oder zusätzlich eingerichtet sein, um eine Steigung der B-H-Kennlinie an einem Sättigungspunkt zu ermitteln.

Die Auswerteschaltung kann alternativ oder zusätzlich eingerichtet sein, um einen Kniepunkt der B-H-Kennlinie und/oder eine Steigung der B-H-Kennlinie am Kniepunkt zu ermitteln.

Die Auswerteschaltung kann eingerichtet sein, um aus der ermittelten Informationen über die B-H-Kennlinie wenigstens einen physikalische Eigenschaft des Transformators zu bestimmen. Die wenigstens eine physikalische Eigenschaft kann eine Information über magnetische Eigenschaften der Hauptinduktivität des Transformators umfassen. Die Transformatorprüfvorrichtung kann eingerichtet sein, um die Information über magnetische Eigenschaften der Hauptinduktivität bei der Parametrisierung des Transformatormodells zu verwenden.

Die Auswerteschaltung kann eingerichtet sein, um den wenigstens einen physikalischen Parameter weiterhin abhängig von einer Parametrisierung eines Transformatormodells des Transformators zu bestimmen. Die Parametrisierung kann von weiteren Kenngrößen, die von der Transformatorprüfvorrichtung automatisch ermittelt werden, abhängen. Beispielsweise kann die Parametrisierung von einem Wicklungsverhältnis, von Streuinduktivitäten oder Streuimpedanzen, von Wicklungswiderständen oder von anderen Kenngrößen abhängen, die von der Transformatorprüfvorrichtung automatisch ermittelt werden.

Die Transformatorprüfvorrichtung kann eine Eingabeschnittstelle zum Eingeben einer Schaltgruppe des Transformators umfassen.

Die Auswerteschaltung kann eingerichtet sein, um die Schaltgruppe des Transformators bei der Ermittlung oder weiteren Auswertung der Informationen über die B-H-Kennlinie zu verwenden. Die Auswerteschaltung kann eingerichtet sein, um die über die Eingabeschnittstelle festlegbare Schaltgruppe zu verwenden, um die zu Parametrisierung den Größen eines Transformatormodells festzulegen.

Die Eingabeschnittstelle kann derart eingerichtet sein, dass die Schaltgruppe des Transformators explizit oder implizit festlegbar ist. Die Eingabeschnittstelle kann derart eingerichtet sein, dass ein Typ des Transformators eingegeben werden kann, wobei die Transformatorprüfvorrichtung aus dem Typ automatisch die Schaltgruppe ermittelt. Dazu kann die Transformatorprüfvorrichtung in einem Speicher nichtflüchtig gespeicherte Informationen über die unterschiedlichen Typen zugeordneten Schaltgruppen speichern oder über eine Schnittstelle Informationen von einem Speichermedium abrufen.

Die Eingabeschnittstelle kann derart eingerichtet sein, dass die Schaltgruppe des Transformators selektiv nur dann eingegeben werden kann, wenn zuvor festgelegt wurde, dass der Transformator ein Dreiphasentransformator ist.

Die Transformatorprüfvorrichtung kann eingerichtet sein, um die Parametrisierung des Transformatormodells teilweise oder vollständig automatisch zu bestimmen. Die Transformatorprüfvorrichtung kann eingerichtet sein, um bei der Parametrisierung des Transformatormodells abhängig von mehreren Messungen, die die Messung zur Bestimmung von Informationen über die B-H-Kennlinie beinhalten, wenigstens ein Wicklungsverhältnis, Wicklungswiderstände, Streuinduktivitäten oder Streuimpedanzen und eine Hauptinduktivität des Transformators zu ermitteln.

Die Auswerteschaltung kann eingerichtet sein, um die Parametrisierung des Transformatormodells abhängig von der Information über die B-H-Kennlinie zu bestimmen.

Zur Parametrisierung des Transformatormodells kann eine Streuinduktivität einer Oberspannungsseite des Transformators, eine Streuinduktivität einer Unterspannungsseite des Transformators, Widerstände von Wicklungen des Transformators, ein Sättigungsverhalten einer Hauptinduktivität des Transformators und/oder Verluste in einem Kern des Transformators bestimmt werden.

Die Transformatorprüfvorrichtung kann eingerichtet sein, um abhängig von den Informationen über die B-H-Kennlinie eine Beschädigung eines Kerns des Transformators zu erkennen.

Die Transformatorprüfvorrichtung kann eingerichtet sein, um abhängig von den Informationen über die B-H-Kennlinie eine Anwesenheit eines Luftspalts zu erkennen.

Die Transformatorprüfvorrichtung kann eingerichtet sein, um abhängig von den Informationen über die B-H-Kennlinie eine Überspannungsfestigkeit des Transformators zu prüfen.

Die Transformatorprüfvorrichtung kann eingerichtet sein, um abhängig von den Informationen über die B-H-Kennlinie einen Wirkungsgrad des Transformators zu prüfen.

Ein System nach einem Ausführungsbeispiel umfasst einen Transformator und eine Transformatorprüfvorrichtung nach einem Ausführungsbeispiel. Die Transformatorprüfvorrichtung ist lösbar mit dem Transformator verbunden.

Ein Verfahren zum Prüfen eines Transformators mit einer Transformatorprüfvorrichtung umfasst ein Erzeugen eines Prüfsignals für den Transformator. Das Verfahren umfasst ein Erfassen einer Prüfantwort des Transformators. Das Verfahren umfasst ein Ermitteln von Informationen über eine B-H-Kennlinie des Transformators, die eine Abhängigkeit einer magnetischen Flussdichte von einer magnetischen Feldstärke im Transformator definiert, basierend auf dem Prüfsignal und der Prüfantwort des Transformators.

Weitere Merkmale des Verfahrens und die damit jeweils erreichten Wirkungen entsprechen den Ausgestaltungen und Wirkungen der Transformatorprüfvorrichtung, die oben beschrieben wurden.

Das Verfahren kann mit der Transformatorprüfvorrichtung oder dem System nach einem Ausführungsbeispiel ausgeführt werden.

Bei den Vorrichtungen, Systemen und Verfahren nach Ausführungsbeispielen kann die Transformatorprüfvorrichtung ein mobiles Transformatorprüfgerät sein. Die Transformatorprüfvorrichtung kann ein Gehäuse aufweisen, in dessen Innenraum die Quelle zum Erzeugen des Prüfsignals und die Auswerteschaltung angeordnet sind.

Bei den Vorrichtungen, Systemen und Verfahren nach Ausführungsbeispielen kann der Transformator ein Leistungstransformator sein.

Der Leistungstransformator kann ein einphasiger oder ein mehrphasiger Leistungstransformator sein.

Die Transformatorprüfvorrichtung kann als ein portables Transformatorprüfgerät ausgestaltet sein.

Transformatorprüfvorrichtungen, Verfahren und Systeme nach Ausführungsbeispielen erlauben eine weitergehende Charakterisierung von Prüflingen bei Transformatorprüfungen. Transformatorprüfvorrichtungen, Verfahren und Systeme nach Ausführungsbeispielen erlauben insbesondere, zusätzliche Informationen über die magnetischen Eigenschaften der Hauptinduktivität des Transformators zu ermitteln und optional automatisch Fehlerzustände zu erkennen, die den Kern des Transformators oder den Abstand zwischen den um den Transformatorkern gewickelten Wicklungen und dem Transformatorkern betreffen.

KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.

Figur 1 zeigt ein System mit einer Transformatorprüfvorrichtung nach einem Ausführungsbeispiel.

Figur 2 zeigt eine B-H-Kennlinie, die von einer Transformatorprüfvorrichtung nach einem Ausführungsbeispiel automatisch aufgenommen werden kann.

Figur 3 zeigt eine $I(t)$ - $\int U(t')dt'$ -Kennlinie, die von einer Transformatorprüfvorrichtung nach einem Ausführungsbeispiel automatisch aufgenommen werden kann, um Informationen über die B-H-Kennlinie zu ermitteln.

Figur 4 zeigt ein System mit einer Transformatorprüfvorrichtung nach einem Ausführungsbeispiel.

Figur 5 ist ein Flussdiagramm eines Verfahrens nach einem Ausführungsbeispiel.

Figur 6 veranschaulicht ein Ersatzschaltbild, das von einer Transformatorprüfvorrichtung nach einem Ausführungsbeispiel automatisch parametrisiert werden kann.

Figur 7 ist ein Flussdiagramm eines Verfahrens nach einem Ausführungsbeispiel.

DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren zur Durchführung einer Transformatorprüfung mit einer Transformatorprüfvorrichtung detailliert beschrieben. Der Transformator kann ein Leistungstransformator sein.

Der Transformator kann ein Transformator für Hoch- oder Mittelspannungsnetze sein. Der Transformator kann ein in einem Kraftwerk oder Umspannwerk installierter Transformator sein. Die Transformatorprüfvorrichtung kann ein mobiles Gerät sein, das die Durchführung der Transformatorprüfung an dem installierten Transformator erlaubt.

Die Transformatorprüfvorrichtung ist eingerichtet, um Informationen über die B-H-Kennlinie des Transformators zu ermitteln. Diese Informationen können Datenpunkte oder charakteristische Parameter der B-H-Kennlinie sein. Es ist nicht unbedingt erforderlich, dass die Transformatorprüfvorrichtung die B-H-Kennlinie selbst aufnimmt. Beispielsweise können Datenpunkte erfasst werden, die den durch eine Wicklung des Transformators fließenden Strom als Maß für die magnetische Feldstärke sowie das Zeitintegral der erfassten Spannung als Reaktion auf den Strom als Maß für den magnetischen Fluss wiedergeben.

Die Transformatorprüfvorrichtung kann eingerichtet sein, um einen Strom als Prüfsignal in eine Wicklung des Transformators einzuspeisen. Die Transformatorprüfvorrichtung kann eingerichtet sein, um den Strom als Prüfsignal an einer Oberspannungsseite oder einer Unterspannungsseite des Transformators einzuspeisen. Die Transformatorprüfvorrichtung kann so eingerichtet sein, dass die Einspeisung des Prüfsignals ohne eine Umverdrahtung zwischen der Transformatorprüfvorrichtung und dem Transformator geändert werden kann, beispielsweise um Messungen an unterschiedlichen Phasen auszuführen.

Die Transformatorprüfvorrichtung kann eingerichtet sein, um den Strom als Gleichstrom oder als einen Wechselstrom mit zeitabhängig veränderlicher Frequenz als das Prüfsignal einzuspeisen.

Die Transformatorprüfvorrichtung kann aus einem oder mehreren mobilen, beispielsweise portablen, Geräten aufgebaut sein.

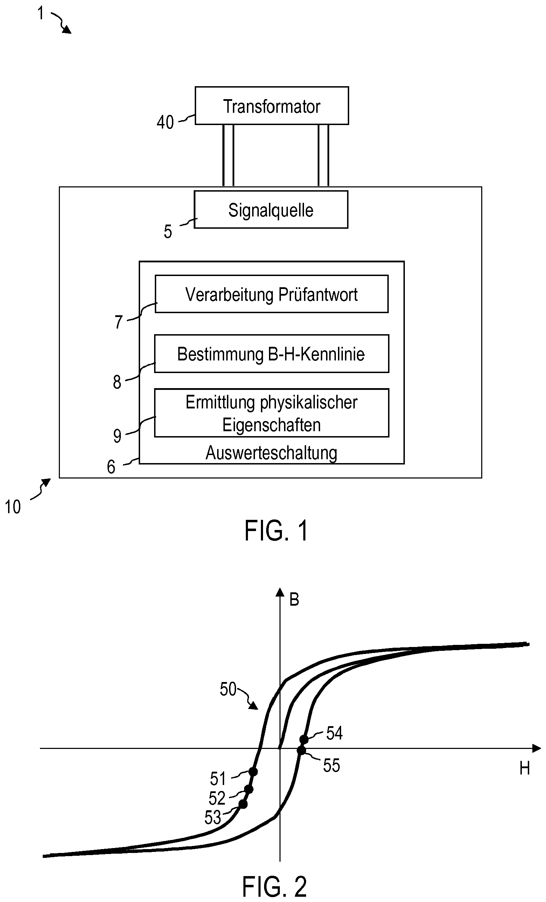

Figur 1 zeigt ein System 1 mit einer Transformatorprüfvorrichtung 10 nach einem Ausführungsbeispiel.

Das System 1 umfasst einen Prüfling, der ein Transformator 40 sein kann, und die Transformatorprüfvorrichtung 10. Die Transformatorprüfvorrichtung 10 kann als ein einziges Gerät mit einem Gehäuse 11 ausgebildet sein. Die Transformatorprüfvorrichtung 10 kann aus einer Anordnung von mehreren Geräten oder Einrichtungen bestehen. Die mehreren Geräte oder Einrichtungen können in diesem Fall von einer zentralen Steuerung gesteuert werden. Die Transformatorprüfvorrichtung 10 kann als mobiles Gerät und insbesondere als portables Gerät ausgebildet sein. Falls die Transformatorprüfvorrichtung 10 aus mehreren Geräten besteht, kann jedes der Geräte als portables Gerät ausgebildet sein.

Der Transformator 40 kann ein Leistungstransformator einer elektrischen Energieversorgungseinrichtung sein. Der Transformator 40 kann fest in einem Kraftwerk oder Umspannwerk verbaut sein, während mit der Transformatorprüfvorrichtung 10 eine Transformatorprüfung ausgeführt wird. Der Transformator 40 kann ein Spannungswandler oder Stromwandler sein. Der Transformator 40 kann ein Spannungswandler oder Stromwandler sein, der nach induktivem Wirkprinzip arbeitet.

Der Transformator 40 umfasst zumindest eine erste Wicklung und eine zweite Wicklung sowie einen Transformatorkern, um den die erste Wicklung und die zweite Wicklung gewickelt sein können. Der Transformator 40 kann ein Dreiphasentransformator sein.

Die Transformatorprüfvorrichtung 10 umfasst mehrere Anschlüsse zur lösbaren Verbindung mit dem Transformator 40, eine Quelle 5 für ein Prüfsignal, das an den Transformator 40 als Prüfling bei der Transformatorprüfung angelegt oder eingeprägt wird, und eine Auswerteschaltung 6.

Die Quelle 5 kann eine Stromquelle sein, die steuerbar ist, um einen Gleichstrom und/oder einen Wechselstrom als Prüfsignal zu erzeugen. Die Quelle 5 kann steuerbar sein, um Wechselströme mit mehreren unterschiedlichen Frequenzen als Prüfsignal zu erzeugen. Die Quelle 5 kann eine Spannungsquelle sein, die steuerbar ist, um eine Gleichspannung und/oder eine Wechselspannung als Prüfsignal zu erzeugen. Die Quelle 5 kann steuerbar sein, um Wechselspannungen mit mehreren unterschiedlichen Frequenzen als Prüfsignal zu erzeugen. Die Quelle 5 kann in unterschiedlichen Betriebsmodi betreibbar sein, beispielsweise als Stromquelle oder als Spannungsquelle und/oder als Quelle eines zeitlich konstanten Signals oder eines Wechselsignals.

Die Quelle 5 kann eine Strommesseinrichtung umfassen. Die Quelle 5 kann eingerichtet sein, um ein Ausgangssignal der Strommesseinrichtung in einer Regelschleife für eine Stromregelung zu verwenden. Alternativ oder zusätzlich kann eine Strommesseinrichtung mit der Quelle 5 in Serie geschaltet sein. Die Stromstärke, die von der in die Quelle 5 integrierten Strommesseinrichtung oder durch eine davon separate Strommesseinrichtung erfasst wird, kann der von der Auswerteschaltung 6 weiter verarbeitet werden, um ein Maß für die magnetische Feldstärke immer Transformatorkern zu erhalten.

Die Auswerteschaltung 6 kann eingerichtet sein, um eine Prüfantwort des Transformators 10 auf das Prüfsignal zu erfassen. Die Prüfantwort kann eine Spannung sein, die an derjenigen Wicklung abfällt, in die der Strom als Prüfsignal eingeprägt wird. Die Prüfantwort kann eine Spannung sein, die an einer weiteren Wicklung abfällt, die von derjenigen Wicklung verschieden ist, in die der Strom als Prüfsignal eingeprägt wird.

Die Auswerteschaltung 6 kann eine Verarbeitungsschaltung 7 zum Verarbeiten der Prüfantwort umfassen. Die Verarbeitungsschaltung 7 kann einen Integrator umfassen, der die als Prüfantwort erfasste Spannung über die Zeit integriert. Die Verarbeitungsschaltung 7 kann einen A/D-Wandler umfassen, der die Prüfantwort umsetzt und für eine numerische Integration der digitalen Abtastwerte der erfassten Spannung bereitstellt. Die Verarbeitungsschaltung 7 kann eingerichtet sein, um die Abtastwerte der erfassten Spannung numerisch über die Zeit zu integrieren. Die Auswerteschaltung 6 kann entsprechend eingerichtet sein, um das Zeitintegral der Spannung als Maß für die magnetische Flussdichte im Transformatorkern zu ermitteln.

Die Auswerteschaltung 6 kann eine Bestimmungseinrichtung 8 zum Bestimmen von Informationen über die B-H-Kennlinie umfassen. Die Bestimmungseinrichtung 8 kann eingerichtet sein, um Datenpunkte einer Kurve zu ermitteln, die die magnetische Flussdichte als Funktion der magnetischen Feldstärke im Transformatorkern angibt oder davon abhängt. Die Bestimmungseinrichtung 8 muss nicht notwendig alle Proportionalitätskonstanten berücksichtigen, die eine Skalierung der B-H-Kennlinie beeinflussen. Beispielsweise können zum Bestimmen charakteristische Kenngrößen der B-H-Kennlinie Zeitintegrale der Spannung, die über einer Wicklung des Transformators als Reaktion auf das Prüfsignal abfallen, jeweils als Funktion der Stromstärke des Prüfsignals erfasst werden. Alternativ oder zusätzlich können charakteristische Parameter der B-H-Kennlinie ermittelt werden, wie beispielsweise die Lage von Nulldurchgängen oder die Steigung der B-H-Kennlinie an die Nulldurchgängen, die Steigung der B-H-Kennlinie an Kniepunkten oder die Steigung der B-H-Kennlinie bei Sättigung.

Die Auswerteschaltung 6 kann eine Diagnoselogik 9 zum weiteren Verarbeiten der Informationen über die B-H-Kennlinie umfassen. Die Diagnoselogik 9 kann eingerichtet sein, um physikalische Parameter des Transformators wenigstens auch abhängig von der B-H-Kennlinie zu ermitteln. Die Diagnoselogik 9 kann eingerichtet sein, um wenigstens einen Parameter eines Ersatzschaltbilds des Transformators, insbesondere wenigstens die Hauptinduktivität des Ersatzschaltbilds, abhängig von den Informationen über die B-H-Kennlinie zu ermitteln. Die Diagnoselogik 9 kann eingerichtet sein, um die B-H-Kennlinie und optional weitere Kenngrößen des Transformators, die von der Transformatorprüfvorrichtung 10 automatisch ermittelt werden, weiter zu verarbeiten, um beispielsweise Beschädigungen des Transformatorkerns oder die Bildung eines Luftspalts zwischen Wicklung und Transformatorkern zu erkennen.

Die Auswerteschaltung 6 kann einen oder mehrere Prozessoren oder Mikroprozessoren, einen oder mehrere Controller, eine oder mehrere anwendungsspezifische Spezialschaltungen (ASICs) oder andere integrierte Halbleiterschaltungen oder Kombinationen der genannten oder andere Halbleiterschaltungen umfassen, um Informationen über die B-H-Kennlinie zu ermitteln oder diese weiter auszuwerten.

Figur 2 zeigt eine beispielhafte B-H-Kennlinie 50, die von der Transformatorprüfvorrichtung 10 nach einem Ausführungsbeispiel bei der Transformatorprüfung automatisch aufgenommen werden kann. Die Transformatorprüfvorrichtung 10 kann Datenpunkte 51-53 der B-H-Kennlinie 50 bei der Transformatorprüfung automatisch ermitteln. Alternativ oder zusätzlich kann die Transformatorprüfvorrichtung 10 so eingerichtet sein, dass sie bestimmte charakteristische Parameter der B-H-Kennlinie 50 automatisch bestimmt. Beispielsweise kann die Lage von Nulldurchgängen 55 der B-H-Kennlinie 50 automatisch bestimmt werden. Alternativ oder zusätzlich kann die Steigung der B-H-Kennlinie 50 an den Nulldurchgängen 55 automatisch bestimmt werden. Dazu können wenigstens zwei Datenpunkte 54, 55 in der Nähe eines Nulldurchgangs erfasst und rechnerisch weiter verarbeitet werden, um die Steigung der B-H-Kennlinie 50 Nulldurchgang 55 zu bestimmen. Ähnlich kann die Transformatorprüfvorrichtung 10 alternativ oder zusätzlich die Lage von Kniepunkten oder Steigung der B-H-Kennlinie an den Kniepunkten oder bei Sättigung ermitteln.

Allgemein kann die Transformatorprüfvorrichtung 10 eingerichtet sein, um bei der Transformatorprüfung automatisch den Zusammenhang zwischen magnetischer Feldstärke und magnetische Flussdichte im Transformatorkern auszuwerten. Es ist nicht erforderlich, dass sie Transformatorprüfvorrichtung 10 zum Ermitteln der Informationen über die B-H-Kennlinie 50 Datenpunkte dieser Kennlinie selbst ermittelt. Beispielsweise kann es ausreichen, Datenpunkte einer Kurve abzutasten, die die Stromstärke doch eine Wicklung des Transformators in Beziehung setzen mit dem Zeitintegral der Spannung. Die Spannung kann an derselben Wicklung, in die ein Gleichstrom oder ein Wechselstrom mit veränderlicher Frequenz als Prüfsignal eingeprägt wird, erfasst werden. Die Spannung kann an einer anderen Wicklung als derjenigen, in die ein Gleichstrom oder ein Wechselstrom mit veränderlicher Frequenz als Prüfsignal eingeprägt wird, erfasst werden.

Die magnetische Feldstärke kann dargestellt werden als

$$H(t) = c_1 I(t), \qquad (1)$$

wobei $c_1$ eine von der Wicklungsgeometrie, der Anzahl der Wicklungen und der Länge der Wicklung abhängige Konstante sein kann.

Die magnetische Flussdichte dargestellt werden als

$$B(t) = c_2 \int_0^t U(t')dt', \qquad (2)$$

wobei $c_2$ eine von Konstante ist und das Zeitintegral durch Integration der Spannung an einer Wicklung des Transformators ab dem Zeitpunkt, an dem das Prüfsignal angelegt wird, ermittelt wird.

Wesentliche Eigenschaften über den Transformator und die magnetischen Eigenschaften seiner Hauptinduktivität können bereits aus einer Kurve, die die Stromstärke zum Zeitintegral der Spannung in Beziehung setzt, erhalten werden. Entsprechend ist es möglich, aber nicht unbedingt erforderlich, dass von der Transformatorprüfvorrichtung auch das Verhältnis der beiden Proportionalitätskonstanten $c_1$ und $c_2$ in Gleichungen (1) und (2) ermittelt wird.

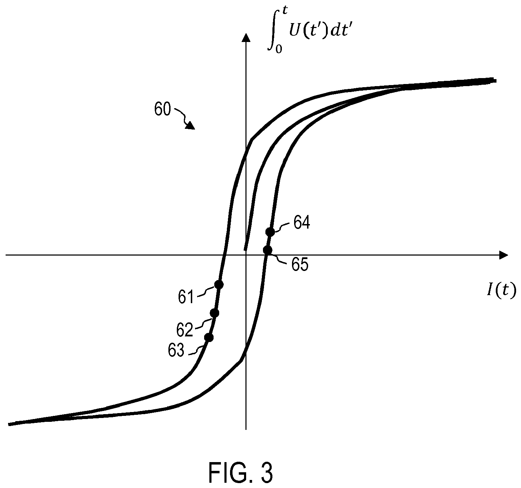

Figur 3 zeigt eine Kurve 60, die den Zusammenhang zwischen dem Zeitintegral der von der Transformatorprüfvorrichtung 10 erfassten Spannung und dem als Prüfsignal eingespeisten Strom darstellt. Die $I(t) - \int U(t')dt'$-Kurve 60 kann der in Figur 2 dargestellten B-H-Kennlinie bis auf Skalierungsfaktoren entlang der beiden Achsen entsprechen. Wichtige Informationen können bereits aus der Form der $I(t) - \int U(t')dt'$-Kurve 60 abgeleitet werden.

Die Transformatorprüfvorrichtung 10 kann entsprechend eingerichtet sein, um Datenpunkte 61-63 der $I(t) - \int U(t')dt'$-Kurve 60 zu bestimmen. Die Transformatorprüfvorrichtung 10 kann alternativ oder zusätzlich eingerichtet sein, um einen Nulldurchgang 65 der $I(t) - \int U(t')dt'$-Kurve 60 zu bestimmen. Die Transformatorprüfvorrichtung 10 kann alternativ oder zusätzlich eingerichtet sein, um aus Datenpunkten 64, 65 in der Nähe des Nulldurchgangs 65 die Steigung der $I(t) - \int U(t')dt'$-Kurve 60 am Nulldurchgang zu bestimmen. Ähnlich kann von der Transformatorprüfvorrichtung die Lage von Kniepunkten oder die Steigung der Kurve 60 an den die Punkten oder bei Sättigung ermittelt werden.

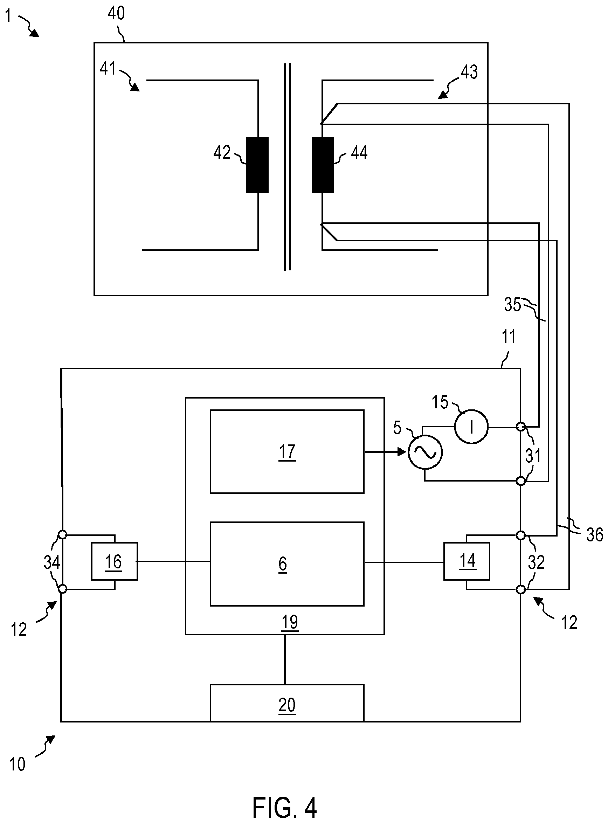

Figur 4 zeigt ein System 1 mit einer Transformatorprüfvorrichtung 10 nach einem Ausführungsbeispiel. Die Transformatorprüfvorrichtung 10 ist für eine lösbare Kopplung mit einem Transformator 40 eingerichtet, um bei einer Transformatorprüfvorrichtung Informationen über eine B-H-Kennlinie zu ermitteln.

Der Transformator 40 weist eine Oberspannungsseite 41 mit einer ersten Wicklung 42 und eine Unterspannungsseite 43 mit einer zweiten Wicklung 44 auf. Der Transformator 40 kann auch als Dreiphasentransformator ausgestaltet sein, wobei die Sekundärwicklungen der unterschiedlichen Phasen auf unterschiedliche Weise gemäß der Schaltgruppe des Transformators 40 miteinander verbunden sein können.

Die Transformatorprüfvorrichtung 10 ist eingerichtet, um ein Prüfsignal, das ein Gleichstrom oder ein Wechselstrom mit veränderlicher Frequenz sein kann, an der ersten Wicklung 42 oder der zweiten Wicklung 44 einzuspeisen. Die Transformatorprüfvorrichtung 10 kann so eingerichtet sein, dass sie sowohl mit der Oberspannungsseite 41 als auch mit der Unterspannungsseite 43 verbunden werden kann, um das Prüfsignal ohne Umverdrahtung wahlweise an der Oberspannungsseite 41 oder der Unterspannungsseite 43 einzuspeisen. Die Einspeisung des Prüfsignals kann wahlweise an der Oberspannungsseite 41 oder an der Unterspannungsseite 43 erfolgen, unabhängig davon, ob die Transformatorprüfvorrichtung mit beiden Seiten oder nur mit derjenigen Seite verbunden ist, an der das Prüfsignal eingespeist wird.

Die Transformatorprüfvorrichtung 10 umfasst eine Quelle 5, die als Stromquelle ausgestaltet sein kann. Die Quelle 5 kann wie unter Bezugnahme auf Figur 1 beschrieben ausgestaltet sein. Die Quelle 5 kann eine Strommesseinrichtung 15 beinhalten oder kann mit einer Showmesseinrichtung 15 in Serie geschaltet sein. Ein von der Strommesseinrichtung 15 erfasster Strom kann von der Auswerteschaltung 6 verwendet werden, um Informationen über die B-H-Kennlinie des Transformators 40 zu ermitteln.

Die Transformatorprüfvorrichtung 10 umfasst eine Mehrzahl von Anschlüssen 12 zur Kopplung mit wenigstens einer Seite des Transformators 40. Die Transformatorprüfvorrichtung 10 kann eine Mehrzahl von Anschlüssen 12 umfassen, die Anschlüsse 34 zur Verbindung mit der Oberspannungsseite 41 und weitere Anschlüsse 31, 32 zur Verbindung mit der Unterspannungsseite 43 des Transformators 40 beinhalten.

Die Transformatorprüfvorrichtung 10 kann eingerichtet sein, um die Quelle 5 wahlweise mit Anschlüssen zur Verbindung mit der Oberspannungsseite 41 oder mit Anschlüssen zur Verbindung mit der Unterspannungsseite 43 des Transformators 40 zu verbinden, ohne dass eine Umverdrahtung der Verbindungen 35, 36 zwischen der Transformatorprüfvorrichtung 10 und dem Transformator 40 erfolgen muss. Die Transformatorprüfvorrichtung 10 kann steuerbare Schaltmittel umfassen, die es erlauben, dass von der Quelle 5 erzeugte Prüfsignal wahlweise an die Oberspannungsseite 41 oder die Unterspannungsseite 43 des Transformators 40 auszugeben.

Die Transformatorprüfvorrichtung 10 kann weitere Einrichtungen umfassen, beispielsweise eine oder mehrere Messeinrichtungen 14, 16 zum Erfassen einer Prüfantwort als Reaktion auf das Prüfsignal. Die Messeinrichtungen 14, 16 können Spannungsmesseinrichtungen sein, beispielsweise Voltmeter.

Die Transformatorprüfvorrichtung 10 kann eine Steuereinrichtung 17 zum automatischen elektrischen Steuern der Quelle 5 umfassen. Die Transformatorprüfvorrichtung 10 umfasst eine Auswerteschaltung 6 zum Auswerten einer Prüfantwort des Transformators 40, die mit den Messeinrichtungen 14, 16 erfasst wird. Die erste Messeinrichtung 14 und die zweite Messeinrichtung 16 können jeweils für eine Spannungsmessung eingerichtet sein. Die Auswerteschaltung 6 kann eingerichtet sein, um ein Zeitintegral der von der ersten Messeinrichtung 14 oder der zweiten Messeinrichtung 16 erfassten Spannung, die über einer Wicklung des Transformators 40 als Reaktion auf das Prüfsignal abfällt, zu bestimmen. Dazu kann die Auswerteschaltung 6 einen Integrator oder A/D-Wandler in Kombination mit einer Einrichtung zur digitalen Integration umfassen. Die Auswerteschaltung 6 kann eingerichtet sein, um eine Stromstärke des von der Quelle 5 ausgegebenen Stroms und ein Zeitintegral der von wenigstens einer der Messeinrichtungen 14, 16 erfassten Spannungen zu ermitteln, um Informationen über die B-H-Kennlinie des Transformators 40 zu bestimmen.

Die Funktionen der Steuereinrichtung 17 und/oder der Auswerteschaltung 6 können von einem Prozessor 19 oder einer anderen integrierten Halbleitschaltung 19 ausgeführt werden.

Die Quelle 6 kann ein zeitlich veränderliches Prüfsignal erzeugen. Eine Frequenz des Prüfsignals kann zwischen mehreren Werten veränderbar sein. Die erste Messeinrichtung 14 und die zweite Messeinrichtung 16 können zur zeitaufgelösten Erfassung einer Prüfantwort eingerichtet sein. Messwerte, die von der ersten Messeinrichtung 14 und der zweiten Messeinrichtung 16 erfasst werden, können A/D-gewandelt und rechnerisch weiter ausgewertet werden, beispielsweise um Kenngrößen des Transformators für jede von mehreren Frequenzen zu bestimmen.

Der Transformator 40 kann auch mehr als zwei Wicklungen 41, 42 umfassen. Die Transformatorprüfvorrichtung 10 kann Anschlüsse zur Verbindung mit einer dritten Wicklung des Transformators 40 und etwaigen weiteren Wicklungen des Transformators 40 umfassen.

Der Transformator 40 kann ein mehrphasiger Leistungstransformator sein. Die Transformatorprüfvorrichtung 10 kann Anschlüsse zur gleichzeitigen Verbindung mit mehreren Phasen des mehrphasigen Leistungstransformators aufweisen.

Die Transformatorprüfvorrichtung 10 kann so eingerichtet sein, dass unterschiedliche Messungen erfolgen können, ohne dass die Verbindungen 35, 36 zwischen der Transformatorprüfvorrichtung 10 und dem Transformator 40 gelöst und/oder anders angeschlossen werden müssen. Die unterschiedlichen Messungen können ausgeführt werden, ohne dass der Prüfling umverdrahtet werden muss. Die Messungen können von der Transformatorprüfvorrichtung 10 vollständig oder teilweise automatisiert, d.h. ohne Interaktion des Benutzers zwischen den Messungen, durchgeführt werden. Die Messungen können die Ermittlung von Informationen über die B-H-Kennlinie sowie weiterer Kenngrößen des Transformators 40 umfassen. Beispielsweise können durch diese weiteren Messungen das Wicklungsverhältnis, Streuimpedanzen oder Streuinduktivitäten, Wicklungswiderstände oder andere Kenngrößen des Transformators 40 ermittelt werden. Die aus diesen Messungen gewonnenen Informationen können verwendet werden, um die verschiedenen Parameter eines Ersatzschaltbildes des Transformators 40 automatisch zu bestimmen. Die Informationen über die B-H-Kennlinie können insbesondere verwendet werden, um den Wert der Hauptinduktivität im Ersatzschaltbild des Transformators zu bestimmen.

Wie unter Bezugnahme auf Figur 1 bis Figur 3 beschrieben wurde, kann die Auswerteschaltung 6 weiterhin eingerichtet sein, um abhängig von der B-H-Kennlinie und optional weiteren Messungen an dem Transformator 40 zu erkennen, ob der Transformatorkern beschädigt ist, sich einen Luftspalt zwischen einer Wicklung und dem Transformatorkern gebildet hat, ob die Überspannungsfestigkeit und der Wirkungsgrad des Transformators 40 in einem zulässigen Bereich liegen, oder ob andere Fehlerzustände vorliegen.

Die weitere Auswertung der B-H-Kennlinie, beispielsweise zur Parametrisierung des Transformatormodells oder zur Erkennung von Fehlerzuständen, kann von der Auswerteschaltung 6 in Abhängigkeit von einer Eingabe vorgenommen werden, die über eine Eingabeschnittstelle 20 empfangen wird. Über die Eingabeschnittstelle 20 kann beispielsweise eingebbar sein, ob der Transformator 40 ein Dreiphasentransformator ist. Falls der Transformator 40 ein Dreiphasentransformator ist, kann die Eingabeschnittstelle 20 selektiv die Festlegung einer Schaltgruppe ermöglichen, zu der der Transformator 40 gehört. Die weitere Auswertung der B-H-Kennlinie kann von der Auswerteschaltung 6 abhängig davon ausgeführt werden, ob der Transformator 40 ein Dreiphasentransformator ist und zu welcher Schaltgruppe der Transformator 40 gegebenenfalls gehört.

Unterschiedliche Phasen des Transformators 40 können von der Transformatorprüfvorrichtung 10 gleichzeitig oder zeitsequenziell geprüft werden.

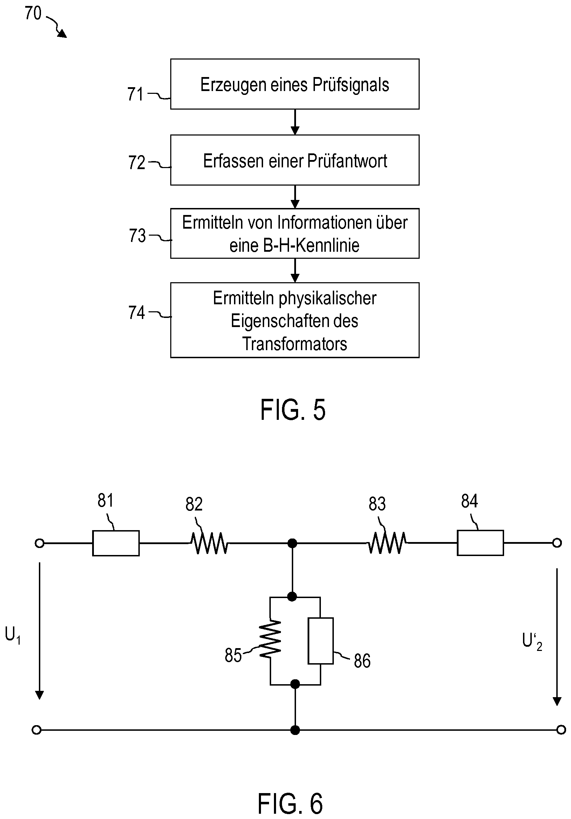

Figur 5 ist ein Flussdiagramm eines Verfahrens 70 nach einem Ausführungsbeispiel. Das Verfahren 70 kann von der Transformatorprüfvorrichtung 10 nach einem Ausführungsbeispiel automatisch ausgeführt werden.

Bei Schritt 71 erzeugt die Transformatorprüfvorrichtung ein Prüfsignal. Das Prüfsignal kann ein Gleichstrom sein. Das Prüfsignal kann ein Wechselstrom sein. Falls das Prüfsignal ein Wechselstrom ist, kann eine Frequenz des Wechselstroms zeitabhängig verändert werden, während die Prüfantwort erfasst wird.

Das Prüfsignal kann in eine Spule an einer Oberspannungsseite oder eine Spule an einer Unterspannungsseite des Transformators 40 eingespeist werden.

Bei Schritt 72 wird eine Prüfantwort des Transformators 40 erfasst. Die Prüfantwort kann eine Spannung sein, die an einer Wicklung des Transformators 40 abfällt, wenn das Prüfsignal angelegt wird.

Bei Schritt 73 werden Informationen über eine B-H-Kennlinie des Transformators 40 ermittelt. Die Informationen können Datenpunkte, die das Zeitintegral der bei Schritt 72 erfassten Spannung jeweils abhängig vom angelegten Strom angeben, umfassen. Die Informationen können Datenpunkte der B-H-Kennlinie oder charakteristische Parameter der B-H-Kennlinie wie beispielsweise die Nulldurchgänge oder Kniepunkte oder die Steigung der B-H-Kennlinie an den Nulldurchgängen, Kniepunkten oder bei Sättigung umfassen.

Die Auswertung bei Schritt 73 kann ein Integrieren der bei Schritt 72 erfassten Spannung umfassen. Eine Auswerteschaltung der Transformatorprüfvorrichtung kann eine Integratorschaltung umfassen, die die Spannung integriert. Alternativ oder zusätzlich kann die Integration numerisch erfolgen, beispielsweise nach einer A/D-Umsetzung.

Bei Schritt 74 können optional physikalische Eigenschaften des Transformators abhängig von den Informationen über die B-H-Kennlinie ermittelt werden. Die ermittelten physikalischen Eigenschaften können von den magnetischen Eigenschaften des Transformatorkerns abhängen. Beispielsweise kann eine Beschädigung des Transformatorkerns automatisch erkannt werden. Alternativ oder zusätzlich kann ein Luftspalt zwischen einer der Wicklungen und dem Transformatorkern automatisch erkannt werden. Alternativ oder zusätzlich können Beeinträchtigungen der Überspannungsfestigkeit oder des Wirkungsgrad des Transformators 40 automatisch erkannt werden.

Die Ermittlung der physikalischen Eigenschaften bei Schritt 74 kann eine Parametrisierung eines Transformatormodells beinhalten. Dabei können die Informationen über die B-H-Kennlinie mit anderen Messungen zusammengeführt werden, die von der Transformatorprüfvorrichtung 40 zeitsequenziell zur Ermittlung der B-H-Kennlinie an dem Transformator 40 ausgeführt werden. Derartige Messungen können beispielsweise zur Ermittlung eines Übersetzungsverhältnisses, von Streuimpedanzen oder Streuinduktivitäten oder Wicklungswiderständen dienen.

Figur 6 zeigt ein Ersatzschaltbild des Transformators 40. Der Wicklungswiderstand $R_1$ der Oberspannungsseite 41 kann durch einen Widerstand 81 repräsentiert werden. Der transformierte Wicklungswiderstand $R_2'$ der Unterspannungsseite 43 kann durch einen Widerstand 84 repräsentiert werden. Die Streuinduktivität $L_{\sigma 1}$ der Oberspannungsseite 41 kann durch eine Induktivität 82 repräsentiert werden. Die transformierte Streuinduktivität $L_{\sigma 2}'$ der Unterspannungsseite

43 kann durch eine Induktivität 83 repräsentiert werden. Die Widerstände 81, 84 und Induktivitäten 82, 83 definieren die gesamte Längsinduktivität des Transformators. Die Induktivitäten 82, 83 definieren die nicht transformierte, d.h. ungestrichene, gesamte Streuinduktivität, die durch Skalierung mit dem Quadrat des Übersetzungsverhältnisses in an sich bekannter Weise in eine gestrichene Kenngröße des Transformators umgerechnet werden kann.

Eine den Magnetisierungsstrom führende Hauptinduktivität kann durch eine Induktivität 85 berücksichtigt werden. Eine lineare Modellierung von Verlusten im Transformatorkern kann durch einen Widerstand 86 erfolgen.

Die Transformatorprüfvorrichtung 10 nach einem Ausführungsbeispiel kann eingerichtet sein, um durch die Ermittlung von Informationen über die B-H-Kennlinie des Transformators wenigstens die Induktivität 85 der den Magnetisierungsstrom führenden Hauptinduktivität zu bestimmen. Eine Parametrisierung des Transformatormodells, bei der die in Figur 6 dargestellten Widerstände und Induktivitäten ermittelt werden, kann von der Transformatorprüfvorrichtung 10 automatisch ausgeführt werden.

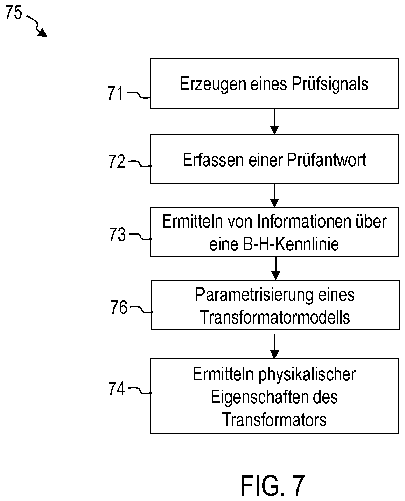

Figur 7 ist ein Flussdiagramm eines Verfahrens 75 nach einem Ausführungsbeispiel. Das Verfahren 75 kann von der Transformatorprüfvorrichtung 10 nach einem Ausführungsbeispiel automatisch ausgeführt werden.

Bei dem Verfahren 75 können Schritte 71 bis 74 wie unter Bezugnahme auf Figur 5 beschrieben ausgeführt werden.

Das Verfahren 75 kann die Parametrisierung eines Transformatormodells bei Schritt 76 beinhalten. Bei der Parametrisierung des Transformatormodells können mehrere Messungen, die einem Transformator 40 ausgeführt wurden, ausgewertet werden, um die verschiedenen Parameter des Transformatormodells zu bestimmen. Diese Parameter können die Hauptinduktivität des Transformators beinhalten, die wenigstens auch abhängig von der ermittelten B-H-Kennlinie bestimmt werden kann.

Während Ausführungsbeispiele unter Bezugnahme auf die Figuren detailliert beschrieben wurden, können bei weiteren Ausführungsbeispielen alternative oder zusätzliche Merkmale verwendet werden. Während beispielsweise die Verwendung einer Transformatorprüfvorrichtung in Kombination mit einem Transformator mit zwei Wicklungen beschrieben wurde, können die Vorrichtungen und Verfahren nach Ausführungsbeispielen auch für Transformatoren mit drei Wicklungen oder mehr als drei Wicklungen verwendet werden.

Während bei Ausführungsbeispielen die Transformatorprüfvorrichtung eine Signalquelle zum erzeugen des Prüfsignals umfassen kann, kann die Transformatorprüfvorrichtung auch zwei oder mehr Quellen umfassen, um Ströme in unterschiedliche Wicklungen des Transformators einzuspeisen.

Während bei Ausführungsbeispielen eine Prüfungsprozedur, die die Bestimmung mehrerer Kenngrößen des Transformators beinhaltet, automatisch ausgeführt werden kann, können die Transformatorprüfvorrichtung und das Verfahren nach Ausführungsbeispielen auch verwendet werden, wenn nur eine Kenngröße des Transformators gemessen wird, bevor eine neue Benutzereingabe erforderlich ist.

Während der Transformator in einem Kraftwerk oder Umspannwerk eines Energieversorgungsnetzes installiert sein kann, können die Transformatorprüfvorrichtung und das Verfahren nach Ausführungsbeispielen auch bei kleineren Transformatoren eingesetzt werden.

Transformatorprüfvorrichtungen, Verfahren und Systeme nach Ausführungsbeispielen erlauben eine weitergehende Charakterisierung eines Transformators bei der Transformatorprüfung. Insbesondere können zusätzliche Informationen über das magnetische Verhalten der Hauptinduktivität gewonnen werden.

## Patentansprüche

1. Mobile Transformatorprüfvorrichtung zum Prüfen eines Leistungstransformators, umfassend Anschlüsse (12) ausgebildet zur lösbaren Verbindung der mobilen Transformatorprüfvorrichtung mit dem Leistungstransformator (40), eine Quelle (5) ausgebildet zum

   Erzeugen eines Prüfsignals für den Leistungstransformator (40), wobei das Prüfsignal ein Strom oder eine Spannung ist, und
   eine Auswerteschaltung (6), die eingerichtet ist, um basierend auf dem Prüfsignal und einer Prüfantwort des Leistungstransformators (40) Informationen über eine B-H-Kennlinie (50, 60) des Leistungstransformators (40), die eine Abhängigkeit einer magnetischen Flussdichte von einer magnetischen Feldstärke im Leistungstransformator (40) definiert, zu bestimmen, wobei die Prüfantwort eine Spannung ist, wobei die Auswerteschaltung (6) eingerichtet ist, um wenigstens einen der folgenden Parameter der B-H-Kennlinie (50, 60) zu bestimmen:

      eine Steigung der B-H-Kennlinie (50, 60) an einem Nulldurchgang (55, 65),
      eine Steigung der B-H-Kennlinie (50, 60) an einem Sättigungspunkt,
      einen Kniepunkt der B-H-Kennlinie (50, 60).

**2.** Mobile Transformatorprüfvorrichtung nach Anspruch 1,
wobei die Auswerteschaltung (6) eingerichtet ist, um aus den ermittelten Informationen über die B-H-Kennlinie (50, 60) wenigstens einen physikalische Eigenschaft des Leistungstransformators (40) zu bestimmen.

**3.** Mobile Transformatorprüfvorrichtung nach Anspruch 2,
wobei die Auswerteschaltung (6) eingerichtet ist, um die wenigstens einen physikalischen Eigenschaft abhängig von einer Parametrisierung eines Transformatormodells des Leistungstransformators (40) zu bestimmen.

**4.** Mobile Transformatorprüfvorrichtung nach Anspruch 3, umfassend
eine Eingabeschnittstelle zum Eingeben einer Schaltgruppe des Leistungstransformators (40), von der das Transformatormodell abhängt.

**5.** Mobile Transformatorprüfvorrichtung nach Anspruch 3 oder Anspruch 4,
wobei die Transformatorprüfvorrichtung (10) eingerichtet ist, um die Parametrisierung des Transformatormodells teilweise oder vollständig automatisch zu bestimmen.

**6.** Mobile Transformatorprüfvorrichtung nach einem der Ansprüche 3 bis 5,
wobei die Auswerteschaltung (6) eingerichtet ist, um die Parametrisierung des Transformatormodells abhängig von der Information über die B-H-Kennlinie (50, 60) zu bestimmen.

**7.** Mobile Transformatorprüfvorrichtung nach einem der Ansprüche 3 bis 6,
wobei zur Parametrisierung des Transformatormodells eine Streuinduktivität (81) einer Oberspannungsseite (41) des Leistungstransformators (40), eine Streuinduktivität (84) einer Unterspannungsseite (42) des Leistungstransformators (40), Widerstände (82, 83) von Wicklungen des Leistungstransformators (40), ein Sättigungsverhalten einer Hauptinduktivität des Leistungstransformators (40) und/oder Verluste in einem Kern des Leistungstransformators (40) bestimmt werden.

**8.** Mobile Transformatorprüfvorrichtung nach einem der vorhergehenden Ansprüche, wobei die Transformatorprüfvorrichtung (10) eingerichtet ist, um wenigstens eine der folgenden Informationen abhängig von der B-H-Kennlinie (50, 60) zu erfassen:

eine Beschädigung eines Kerns des Leistungstransformators (40),
eine Anwesenheit eines Luftspalts,
eine Überspannungsfestigkeit des Leistungstransformators (40),
einen Wirkungsgrad des Leistungstransformators (40).

**9.** Mobile Transformatorprüfvorrichtung nach einem der vorhergehenden Ansprüche, wobei die Auswerteschaltung (6) eingerichtet ist, um Datenpunkte der B-H-Kennlinie (50, 60) oder wenigstens einen Parameter der B-H-Kennlinie (50, 60) aus dem Prüfsignal und der Prüfantwort zu bestimmen.

**10.** Mobile Transformatorprüfvorrichtung nach einem der vorhergehenden Ansprüche, wobei die Auswerteschaltung (6) eingerichtet ist, um ein Zeitintegral einer Spannung an wenigstens einer Wicklung des Leistungstransformators (40) zu ermitteln.

**11.** Mobile Transformatorprüfvorrichtung nach Anspruch 10,
wobei die Auswerteschaltung (6) eingerichtet ist, um aus dem Zeitintegral der Spannung die magnetische Flussdichte oder eine zur magnetischen Flussdichte proportionale Größe zu bestimmen.

**12.** Mobile Transformatorprüfvorrichtung nach einem der vorhergehenden Ansprüche, wobei die Auswerteschaltung (6) eingerichtet ist, um einen in wenigstens einer Wicklung des Leistungstransformators (40) fließenden Strom zu erfassen, und wobei die Auswerteschaltung (6) eingerichtet ist, um aus dem in wenigstens einer Wicklung des Leistungstransformators (40) fließenden Strom die magnetische Feldstärke zu bestimmen.

**13.** System, umfassend

einen Leistungstransformator (40) und
eine mobile Transformatorprüfvorrichtung (10) nach einem der vorhergehenden Ansprüche, wobei die Transformatorprüfvorrichtung (10) lösbar mit dem Leistungstransformator (40) verbunden ist.

**14.** Verfahren zum Prüfen eines Leistungstransformators (40) mit einer mobilen Transformatorprüfvorrichtung (10), umfassend:

Erzeugen eines Prüfsignals für den Leistungstransformator (40), wobei das Prüfsignal ein Strom oder eine Spannung ist,
Erfassen einer Prüfantwort des Leistungstransformators (40), wobei die Prüfantwort eine Spannung ist, und
Ermitteln von Informationen über eine B-H-Kennlinie (50, 60) des Leistungstransformators (40), die eine Abhängigkeit einer magnetischen Flussdichte von einer magnetischen Feldstärke im Leistungstransformator (40) definiert, basierend auf dem Prüfsignal und der Prüfantwort des Leistungstransformators (40), wobei wenigstens einer der folgenden Parameter der B-H-Kennlinie (50, 60) bestimmt wird:

eine Steigung der B-H-Kennlinie (50, 60) an einem Nulldurchgang (55, 65),
eine Steigung der B-H-Kennlinie (50, 60) an einem Sättigungspunkt,
ein Kniepunkt der B-H-Kennlinie (50, 60).

**15.** Verfahren nach Anspruch 14, das von der mobilen Transformatorprüfvorrichtung (10) nach einem der Ansprüche 1 bis 12 ausgeführt wird.


**Claims**

**1.** A mobile transformer test device for testing a power transformer, comprising

connectors (12) configured for a detachable connection of the mobile transformer test device to the power transformer (40),
a source (5) configured for generating a test signal for the power transformer (40), wherein the test signal is a current or a voltage, and
an evaluation circuit (6) configured to determine, based on the test signal and a test response of the power transformer (40), information regarding a B-H characteristic curve (50, 60) of the power transformer (40), which defines a dependence of a magnetic flux density on a magnetic field strength in the power transformer (40), wherein the test response is a voltage, wherein the evaluation circuit (6) is configured to determine at least one of the following parameters of the B-H characteristic curve (50, 60):

a gradient of the B-H characteristic curve (50, 60) at a zero crossing (55, 65),
a gradient of the B-H characteristic curve (50, 60) at a saturation point,
a knee point of the B-H characteristic curve (50, 60).

**2.** The mobile transformer test device according to claim 1,
wherein the evaluation circuit (6) is configured to determine at least one physical property of the power transformer (40) from the ascertained information regarding the B-H characteristic curve (50, 60).

**3.** The mobile transformer test device according to claim 2,
wherein the evaluation circuit (6) is configured to determine the at least one physical property depending on a parameterization of a transformer model of the power transformer (40).

**4.** The mobile transformer test device according to claim 3, comprising
an input interface for inputting a switching group of the power transformer (40), on which switching group the transformer model depends.

**5.** The mobile transformer test device according to claim 3 or claim 4,
wherein the transformer test device (10) is configured to determine the parameterization of the transformer model partly or completely automatically.

**6.** The mobile transformer test device according to any one of claims 3 to 5, wherein the evaluation circuit (6) is configured to determine the parameterization of the transformer model depending on the information regarding the B-H characteristic curve (50, 60).

**7.** The mobile transformer test device according to any one of claims 3 to 6, wherein, to parameterize the transformer model, a leakage inductance (81) of a high-voltage side (41) of the power transformer (40), a leakage inductance (84) of a low-voltage side (42) of the power transformer (40), resistances (82, 83) of windings of the power transformer (40), a saturation behavior of a main inductance of the power transformer (40) and/or losses in a core of the power transformer (40) are determined.

8. The mobile transformer test device according to any one of the preceding claims,
wherein the transformer test device (10) is configured to detect at least one of the following items of information depending on the B-H characteristic curve (50, 60):

   a damage to a core of the power transformer (40),
   a presence of an air gap,
   an overvoltage resistance of the power transformer (40),
   an efficiency of the power transformer (40).

9. The mobile transformer test device according to any one of the preceding claims,
wherein the evaluation circuit (6) is configured to determine data points of the B-H characteristic curve (50, 60) or at least one parameter of the B-H characteristic curve (50, 60) from the test signal and the test response.

10. The mobile transformer test device according to any one of the preceding claims,
wherein the evaluation circuit (6) is configured to ascertain a time integral of a voltage at at least one winding of the power transformer (40).

11. The mobile transformer test device according to claim 10,
wherein the evaluation circuit (6) is configured to determine the magnetic flux density or a variable proportional to the magnetic flux density from the time integral of the voltage.

12. The mobile transformer test device according to any one of the preceding claims,

   wherein the evaluation circuit (6) is configured to detect a current flowing in at least one winding of the power transformer (40), and
   wherein the evaluation circuit (6) is configured to determine the magnetic field strength from the current flowing in the at least one winding of the power transformer (40).

13. A system, comprising

   a power transformer (40), and
   a mobile transformer test device (10) according to any one of the preceding claims, wherein the transformer test device (10) is connected detachably to the power transformer (40).

14. A method for testing a power transformer (40) using a mobile transformer test device (10), comprising:

   generating a test signal for the power transformer (40), wherein the test signal is a current or a voltage,
   detecting a test response of the power transformer (40), wherein the test response is a voltage, and
   determining information regarding a B-H characteristic curve (50, 60) of the power transformer (40), which defines a dependence of a magnetic flux density on a magnetic field strength in the power transformer (40), based on the test signal and the test response of the power transformer (40), wherein at least one of the following parameters of the B-H characteristic curve (50, 60) is determined:

      a gradient of the B-H characteristic curve (50, 60) at a zero crossing (55, 65),
      a gradient of the B-H characteristic curve (50, 60) at a saturation point,
      a knee point of the B-H characteristic curve (50, 60).

15. The method according to claim 14, which is performed by the mobile transformer test device (10) according to any one of claims 1 to 12.

**Revendications**

1. Dispositif de test de transformateur mobile permettant de tester un transformateur de puissance, comprenant des connecteurs (12) destinés à la connexion amovible du dispositif de test de transformateur mobile au transformateur de puissance (40),

   une source (5) destinée à la génération d'un signal de test pour le transformateur de puissance (40), le signal de test étant un courant ou une tension, et
   un circuit d'évaluation (6) qui est configuré pour, sur la base du signal de test et d'une réponse de test du transformateur de puissance (40), déterminer des informations concernant une caractéristique B-H (50, 60) du transformateur de puissance (40) qui définit une dépendance entre une densité de flux magnétique et une intensité de champ magnétique dans le transformateur de puissance (40), la réponse de test étant une tension, le circuit d'évaluation (6) étant configuré pour déterminer au moins l'un des paramètres suivants de la caractéristique B-H (50, 60) :

   une pente de la caractéristique B-H (50, 60) à un passage par zéro (55, 65),
   une pente de la caractéristique B-H (50, 60) à un point de saturation,
   un coude de la caractéristique B-H (50, 60).

2. Dispositif de test de transformateur mobile selon la revendication 1, dans lequel le circuit d'évaluation (6) est configuré pour déterminer au moins une propriété physique du transformateur de puissance (40) à partir des informations obtenues concernant la caractéristique B-H (50, 60).

3. Dispositif de test de transformateur mobile selon la revendication 2, dans lequel le circuit d'évaluation (6) est configuré pour déterminer l'au moins une propriété physique en fonction d'un paramétrage d'un modèle de transformateur du transformateur de puissance (40).

4. Dispositif de test de transformateur mobile selon la revendication 3, comprenant une interface d'entrée permettant d'entrer un groupe de commutation du transformateur de puissance (40) dont dépend le modèle de transformateur.

5. Dispositif de test de transformateur mobile selon la revendication 3 ou la revendication 4, dans lequel le dispositif de test de transformateur (10) est configuré pour déterminer partiellement ou entièrement automatiquement le paramétrage du modèle de transformateur.

6. Dispositif de test de transformateur mobile selon l'une des revendications 3 à 5, dans lequel le circuit d'évaluation (6) est configuré pour déterminer le paramétrage du modèle de transformateur en fonction des informations concernant la caractéristique B-H (50, 60).

7. Dispositif de test de transformateur mobile selon l'une des revendications 3 à 6, dans lequel une inductance de fuite (81) d'un côté haute tension (41) du transformateur de puissance (40), une inductance de fuite (84) d'un côté basse tension (42) du transformateur de puissance (40), des résistances (82, 83) d'enroulements du transformateur de puissance (40), un comportement de saturation d'une inductance principale du transformateur de puissance (40) et/ou des pertes dans un noyau du transformateur de puissance (40) sont déterminés pour le paramétrage du modèle de transformateur.

8. Dispositif de test de transformateur mobile selon l'une des revendications précédentes, dans lequel le dispositif de test de transformateur (10) est configuré pour détecter au moins l'une des informations suivantes en fonction de la caractéristique B-H (50, 60) :

   une détérioration d'un noyau du transformateur de puissance (40),
   une présence d'un entrefer,
   une résistance à la surtension du transformateur de puissance (40),
   une efficacité du transformateur de puissance (40).

9. Dispositif de test de transformateur mobile selon l'une des revendications précédentes, dans lequel le circuit d'évaluation (6) est configuré pour déterminer des points de données de la caractéristique B-H (50, 60) ou au moins un paramètre de la caractéristique B-H (50, 60) à partir du signal de test et de la réponse de test.

**10.** Dispositif de test de transformateur mobile selon l'une des revendications précédentes, dans lequel le circuit d'évaluation (6) est configuré pour obtenir une intégrale de temps d'une tension sur au moins un enroulement du transformateur de puissance (40).

**11.** Dispositif de test de transformateur mobile selon la revendication 10, dans lequel le circuit d'évaluation (6) est configuré pour déterminer la densité de flux magnétique ou une variable proportionnelle à la densité de flux magnétique à partir de l'intégrale de temps de la tension.

**12.** Dispositif de test de transformateur mobile selon l'une des revendications précédentes, dans lequel le circuit d'évaluation (6) est configuré pour détecter un courant circulant dans au moins un enroulement du transformateur de puissance (40), et dans lequel le circuit d'évaluation (6) est configuré pour déterminer l'intensité de champ magnétique à partir du courant circulant dans au moins un enroulement du transformateur de puissance (40).

**13.** Système, comprenant

un transformateur de puissance (40) et
un dispositif de test de transformateur mobile (10) selon l'une des revendications précédentes, le dispositif de test de transformateur mobile (10) étant connecté de manière amovible au transformateur de puissance (40).

**14.** Procédé permettant de tester un transformateur de puissance (40) comportant un dispositif de test de transformateur mobile (10), comprenant :

la génération d'un signal de test pour le transformateur de puissance (40), le signal de test étant un courant ou une tension,
la détection d'une réponse de test du transformateur de puissance (40), la réponse de test étant une tension, et
l'obtention d'informations concernant une caractéristique B-H (50, 60) du transformateur de puissance (40) qui définit une dépendance entre une densité de flux magnétique et une intensité de champ magnétique dans le transformateur de puissance (40), sur la base du signal de test et de la réponse de test du transformateur de puissance (40), au moins l'un des paramètres suivants de la caractéristique B-H (50, 60) étant déterminé :

une pente de la caractéristique B-H (50, 60) à un passage par zéro (55, 65),
une pente de la caractéristique B-H (50, 60) à un point de saturation,
un coude de la caractéristique B-H (50, 60).

**15.** Procédé selon la revendication 14, exécuté par le dispositif de test de transformateur mobile (10) selon l'une des revendications 1 à 12.

1

Transformator

40

Signalquelle

5

Verarbeitung Prüfantwort

7

Bestimmung B-H-Kennlinie

8

Ermittlung physikalischer
Eigenschaften

9

Auswerteschaltung

6

10

FIG. 1

B

50

54

55

H

51

52

53

FIG. 2

FIG. 3

FIG. 4

70

71 ⌐ | Erzeugen eines Prüfsignals |

↓

72 ⌐ | Erfassen einer Prüfantwort |

↓

73 ⌐ | Ermitteln von Informationen über eine B-H-Kennlinie |

↓

74 ⌐ | Ermitteln physikalischer Eigenschaften des Transformators |

## FIG. 5

81  82  83  84

$U_1$          $U'_2$

85  86

## FIG. 6

FIG. 7

**EP 3 391 063 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1653238 A1
- EP 1398644 A1
- EP 2787357 A1
- CN 104749537 A
- JP 60040971 A